# EUROPÄISCHE PATENTSCHRIFT

(11) **EP 0 400 425 B1**
(45) Veröffentlichungstag und Bekanntmachung des Hinweises auf die Patenterteilung: **07.09.1994**
(21) Anmeldenummer: 90109513.3
(22) Anmeldetag: 18.05.1990
(51) Int. Cl.: H03B 5/36, H03K 3/283

(54) **Oszillatorschaltung für differentielle Ausgangssignale**
Oscillator circuit with differential output
Oscillateur à sortie différentielle

(30) Priorität: 31.05.1989 EP 89109838
(43) Veröffentlichungstag der Anmeldung: 05.12.1990
(73) Patentinhaber: SIEMENS AKTIENGESELLSCHAFT, 80333 München (DE)
(72) Erfinder: Fenk, Josef, Dipl.-Ing., D-8057 Eching/Ottenburg (DE)

(56) Entgegenhaltungen:
- NL-A- 6 609 487
- US-A- 3 997 796
- US-A- 4 353 039

## Beschreibung

Die Erfindung betrifft eine Oszillatorschaltung nach dem Oberbegriff des Patentanspruches 1.

Solche Oszillatorschaltungen, insbesondere mit einem symmetrischen Ausgang zum Bereitstellen differentieller Signale, sind prinzipiell unter anderem aus Tietze/Schenk, "Halbleiter-Schaltungstechnik", 3. Auflage, Nachdruck 1976, Seite 427, Tietze/Schenk, "Halbleiter-Schaltungstechnik", 7. Auflage, 1985, Seite 451 und aus dem Valvo Handbuch "Signetics Mikroprozessoren 1977-1978", Seite 119 bekannt. US-A-4 353 039 zeigt ein weiteres Beispiel. In diesen Schriften werden Oszillatorschaltungen gezeigt mit monolithisch integrierbarem Oszillator-Verstärker, bestehend aus einem ersten Transistor und einem zweiten Transistor, wobei der Emitteranschluß des ersten Transistors über eine erste Stromquelle bzw. einen ersten Widertand an ein erstes Versorgungspotential geschaltet ist, wobei der Emitter des zweiten Transistors über eine zweite Stromquelle bzw. einen zweiten Widerstand an dieses erste Versorgungspotential geschaltet ist, wobei der Kollektoranschluß des ersten Transistors einen ersten Signalausgang bildet und über einen dritten Widerstand an ein zweites, vom ersten Versorgungspotential verschiedenes Versorgungspotential geschaltet ist, wobei der Kollektoranschluß des zweiten Transistors einen zweiten Signalausgang bildet und über einen vierten Widerstand an dieses zweite Versorgungspotential geschaltet ist, wobei der Emitteranschluß des ersten Transistors über einen Schwingquarz als Koppelglied mit stark frequenzabhängiger Impedanz mit dem Emitteranschluß des zweiten Transistors verbunden ist, wobei der erste Signalausang an den Steuereingang des zweiten Transistors geschaltet ist und wobei der zweite Signalausgang an den Steuereingang des ersten Transistors geschaltet ist.

In der oben erwähnten 7. Auflage des Buches von Tietze/Schenk sowie in dem Valvo Handbuch ist hierbei jeweils der erste und der zweite Signalausgang unmittelbar an den Steuereingang des zweiten bzw. ersten Transistors geschaltet. Den Schaltungen, die der 3. und der 7. Auflage des oben erwähnten Buches von Tietze/Schenk zu entnehmen sind, ist gemeinsam, daß die Emitteranschlüsse des ersten und des zweiten Transistors jeweils über einen Widerstand an das erste Versorgungspotential geschaltet sind. Der 7. Auflage des Buches von Tietze/Schenk ist auf Seite 451 zu entnehmen, daß durch entsprechende Wahl der Emitterwiderstände die Steilheit der Transistoren und somit die Mitkopplung einstellbar ist und daß bei entsprechend geringer Mitkopplung ein sinusförmiges Signal am Ausgang der Schaltung anliegt. In der 3. Auflage des Buches von Tietze/Schenk sind die Signalausgänge jeweils über ein als Spannungsteiler geschaltetes Widerstandsnetzwerk an den Steuereingang des entsprechenden Transistors geschaltet, so daß der Mitkoppelfaktor begrenzt werden kann und der Arbeitspunkt der Transistoren so gewählt werden kann, daß das Ausgangssignal sinusförmig ist. Hierzu ist der Steuereingang des ersten und der Steuereingang des zweiten Transistors jeweils über Widerstände an das erste und das zweite Versorgungspotential geschaltet. In der Schaltung nach dem Valvo-Handbuch sind die Emitteranschlüsse des ersten und des zweiten Transistors je über eine Stromquelle an das erste Versorgungspotential geschaltet.

Bei monolithisch integrierten Schaltungen ist es möglich, daß es, insbesondere, wenn mehrere Frequenzen innerhalb eines Schaltkreises auftreten, zum Einkoppeln von Signalen mit unerwünschten Frequenzen kommen kann. Dieser Effekt tritt unter anderem auf, wenn benachbarte Schaltungsteile Signale unterschiedlicher Sollfrequenz erzeugen oder verarbeiten. Aber auch über die Versorgungspotentialleitungen können Signalanteile unerwünschter Frequenz in eine Schaltung gelangen. Dies kann in Oszillatorverstärkern einerseits dazu führen, daß diese unerwünschten Spektralanteile am Ausgang des Oszillators dem gewünschten Ausgangsspektrum überlagert werden. Eine derartige Beeinflussung des Oszillator-Ausgangssignales tritt jedoch aufgrund der Gleichtaktunterdrückung bei oben beschriebenen Oszillatorschaltungen mit differentiellen Ausgangssignalen nicht auf. Andererseits kann das Einkoppeln von Signalen unerwünschter Frequenzen, genauso wie - bei Verwendung eines Schwingquarzes als Koppelglied - ein zu starkes Streuen der Schwingquarzparameter dazu führen, daß der Oszillator nicht auf der gewünschten Frequenz sondern auf irgendeiner Oberwelle der Grundfrequenz des Koppelgliedes, bevorzugt der zweiten Harmonischen, schwingt. Außerdem ist der Oberwellenabstand des Oszillatorausgangssignales bei oben beschriebenen, bekannten Sinusoszillatoren lediglich durch die Güte des Schwingquarzes bzw. Koppelgliedes und somit auch durch den Preis des Schwingquarzes bzw. Koppelgliedes und durch die Größe des Arbeitspunktstromes im Oszillatorverstärker verbesserbar. Der Arbeitspunktstrom des Oszillatorverstärkers sollte jedoch zumindest in integrierten Schaltkreisen aufgrund der dadurch bedingten Verlustleistung möglichst klein sein, ein üblicher Wert von 0,6 mA liefert einen brauchbaren Kompromiß zwischen günstigem Ausgangssignal und geringer Verlustleistung.

Eine Problemstelle bei monolithisch integrierten Oszillatorverstärkerschaltungen ist dadurch gegeben, daß die Anschlußklemmen für das Koppelglied nach außen geführt sind. Hierbei treten aufgrund der Leitungsanordnungen und der dadurch bedingten parasitären Elemente Störungen in Abhängigkeit vom Oberwellenabstand auf. Außerdem können Störsignale eingekoppelt werden.

Aufgabe der Erfindung ist das Bereitstellen eines Oszillators für differentielle sinusförmige Signale, bei dem die Abhängigkeit der Ausgangsfrequenz und der Oberwellenabstand des Oszillatorsignales von Parameterschwankungen des Koppelgliedes und von unerwünschten Störsignalen minimiert ist.

Diese Aufgabe wird erfindungsgemäß durch eine Oszillatorschaltung nach dem Patentanspruch 1 gelöst.

Besonders günstige Ausführungsformen sind Gegenstand von Unteransprüchen.

Nachstehend wird die Erfindung anhand der Figuren und anhand besonderer Ausführungsbeispiele näher beschrieben.

Es zeigt:
- FIG 1: das Prinzipschaltbild einer erfindungsgemäßen Oszillatorschaltung
- FIG 2: ein besonders günstiges Ausführungsbeispiel einer erfindungsgemäßen Oszillatorschaltung.
- FIG 3: ein Ausführungsbeispiel nach FIG 2 unter Berücksichtigung der besonderen Bedingungen bei monolithischer Integration.

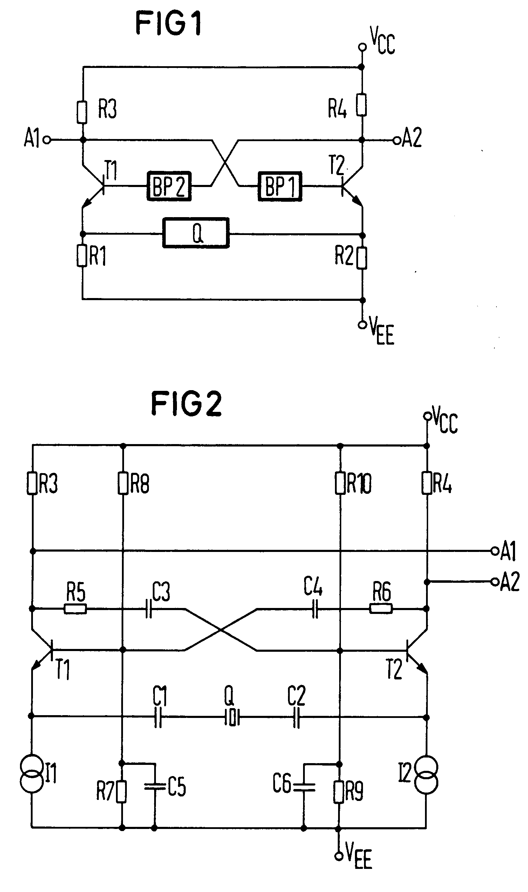

FIG 1 zeigt eine Oszillatorschaltung mit monolithisch integrierbarem Oszillator-Verstärker, bestehend aus einem ersten Transitor T1 und einem zweiten Transistor T2, wobei der Emitteranschluß des ersten Transistors T1 über einen ersten Widertand R1 an ein erstes Versorgungspotential V_{EE} geschaltet ist, wobei der Emitter des zweiten Transistors T2 über einen zweiten Widerstand R2 an dieses erste Versorgungspotential V_{EE} geschaltet ist, wobei der Kollektoranschluß des ersten Transistors T1 einen ersten Signalausgang A1 bildet und über einen dritten Widerstand R3 an ein zweites, vom ersten Versorgungspotential V_{EE} verschiedenes Versorgungspotential V_{CC} geschaltet ist, wobei der Kollektoranschluß des zweiten Transistors T2 einen zweiten Signalausgang A2 bildet und über einen vierten Widerstand R4 an dieses zweite Versorgungspotential V_{CC} geschaltet ist, wobei der Emitteranschluß des ersten Transistors T1 über einen Schwingquarz als Koppelglied Q mit stark frequenzabhängiger Impedanz mit dem Emitteranschluß des zweiten Transistors T2 verbunden ist, wobei der erste Signalausang A1 über eine erste Badpaßschaltung BP1 an den Steuereingang des zweiten Transistors T2 geschaltet ist und wobei der zweite Signalausgang A2 über eine erste Bandpaßschaltung BP2 an den Steuereingang des ersten Transistors T1 geschaltet ist.

Um ein sinusförmiges Ausgangssignal an den Signalausgängen A1 und A2 der Oszillatorschaltung zu erhalten, sollten die Transistoren T1 und T2 in einem möglichst linearen Bereich ihrer Kennlinie angesteuert werden. Hierzu sollte der Gleichspannungsarbeitspunkt jedes einzelnen Transistors sowie die eine Mittkopplung bewirkenden, über die Bandpaßschaltungen BP1 und BP2 an die Steuereingänge der Transistoren T1 und T2 angelegten Signalamplituden entsprechend gewählt werden. Die Arbeitspunkte können hierbei in bekannter Weise dadurch eingestellt werden, daß die Steuereingänge der Transistoren T1 und T2 jeweils über Widerstände an die Versorgungspotentiale geschaltet sind. Die an die Steuereingänge der Transistoren T1 und T2 angelegten Signale können zum einen durch entsprechende Wahl der Verstärkungsfaktoren der Transistoren T1 und T2 zum anderen durch Spannungsteilerschaltungen bzw. über die Dämpfungsfaktoren der Bandpaßschaltungen BP1 und BP2 variiert werden. Die hierzu erforderlichen Maßnahmen gehören zum allgemeinen Fachwissen und sind unter anderem den oben erwähnten Büchern entnehmbar.

Als Koppelglied wird üblicherweise aufgrund der guten Verfügbarkeit und des geringen Preises ein Schwingquarz vorgesehen. Es kann aber auch jedes andere Koppelglied eingesetzt werden, das in ähnlicher Weise eine frequenzabhängige Impedanz aufweist.

Die die Mitkopplung bewirkenden Bandpasschaltungen BP1 und BP2 können in irgendeiner bekannten Weise realisiert werden. Siehe hierzu Tietze/Schenk, Halbleiter-Schaltungstechnik, 3. Auflage, Nachdruck 1976, Seiten 16-18 und Seiten 335-344 sowie 7. Auflage, 1985, Seiten 17-21 und Seiten 413-423. Eine sehr einfache Realisierungsmöglichkeit einer Bandpasschaltung ist dadurch gegeben, daß der Eingang dieser Bandpasschaltung über ein Serien-RC-Glied mit dem Ausgang des Bandpasses verbunden ist und der Ausgang des Bandpasses über ein Parallel-RC-Glied an ein Bezugspotential geschaltet ist. Mit Hilfe solcher Bandpasschaltungsanordnungen ist das besondere Ausführungsbeispiel realisiert, das in Figur 2 gezeigt wird.

FIG 2 zeigt eine Oszillatorschaltung mit monolithisch integrierbarem Oszillator-Verstärker, bestehend aus einem ersten Transitor T1 und einem zweiten Transistor T2, wobei der Emitteranschluß des ersten Transistors T1 über eine erste Stromquelle I1 an ein erstes Versorgungspotential V_{EE} geschaltet ist, wobei der Emitter des zweiten Transistors T2 über eine zweite Stromquelle I2 an dieses erste Versorgungspotential V_{EE} geschaltet ist, wobei der Kollektoranschluß des ersten Transistors T1 einen ersten Signalausgang A1 bildet und über einen dritten Widerstand R3 an ein zweites, vom ersten Versorgungspotential V_{EE} verschiedenes Versorgungspotential V_{CC} geschaltet ist, wobei der Kollektoranschluß des zweiten Transistors T2 einen zweiten Signalausgang A2 bildet und über einen vierten Widerstand R4 an dieses zweite Versorgungspotential V_{CC} geschaltet ist, wobei der Emitteranschluß des ersten Transistors T1 über die Serienschaltung einer ersten Kapazität C1, eines Schwingquarzes und einer zweiten Kapazität C2 mit dem Emitteranschluß des zweiten Transistors T2 verbunden ist, wobei der erste Signalausang R1 über die Serienschaltung eines fünften Widerstandes R5 und einer dritten Kapazität C3 an den Steuereingang des zweiten Transistors T2 geschaltet ist, wobei der zweite Signalausgang A2 über die Serienschaltung eines sechsten Widerstandes R6 und einer vierten Kapazität C4 an den Steuereingang des ersten Transistors T1 geschaltet ist, wobei der Steuereingang des ersten Transistors T1 über die Parallelschaltung eines siebten Widerstandes R7 und einer fünften Kapazität C5 an das erste Versorgungspotential V_{EE} geschaltet ist und über einen achten Widerstand R8 an das zweite Versorgungspotential V_{CC} geschaltet ist und wobei der Steuereingang des zweiten Transistors T2 über die Parallelschaltung eines neunten Widerstandes R9 und einer sechsten Kapazität C6 an das erste Versorgungspotential V_{EE} geschaltet ist und über einen zehnten Widerstand R10 an das zweite Versorgungspotential V_{CC} geschaltet ist.

Durch den symmetrischen Aufbau des verwendeten Koppelgliedes aus einer ersten und einer vorzugsweise mit dieser identischen zweiten Kapazität C₁ und C₂ und einem Schwingquarz Q wird eine Beeinträchtigung der Gleichtaktunterdrückung des symmetrischen Oszillatorverstärkers, wie sie bei Verwendung einer Serienschaltung aus einer einzigen Kapazität und einem Schwingquarz auftreten würde, vermieden.

Würde die Mitkopplung nicht über Bandpaßschaltungen, sondern über Tiefpaßschaltungen erreicht, so würde dadurch die Schwingfrequenz der Oszillatorschaltung sehr stark unterhalb der Serienresonanzfrequenz des Koppelgliedes liegen. Bei Verwendung eines Schwingquarzes in Serie mit einer oder mehreren Kapzitäten würde die Abweichung der Oszillatorfrequenz von der Serienresonanzfrequenz des Quarzes nicht durch entsprechende Wahl der Kapazitätswerte vollständig kompensiert werden können, so daß ein sinusförmiges Ausgangssignal mit durch den Quarz nicht ganz definierbarer Frequenz erzielt würde.

Die Mitkopplung in erfindungsgemäßen Schaltungsanordnungen über Bandpaßschaltungen ermöglicht je nach Wahl der Bandpaßschaltung ein Festlegen der Oszillatorfrequenz auf der Grundwellen- oder einer Oberwellenfrequenz der Serienresonanzfrequenz des Quarzes. Hierbei werden keine großen Anforderungen an die Genauigkeit der Mittenfrequenz, der Flankensteilheit und der Eckfrequenzwerte dieser Bandpaßschaltungen gestellt.

Um in einer integrierten Schaltung die genaue Größenabstimmung des siebten und des neunten Widerstandes R7, R9 sowie der fünften und der sechsten Kapazität C5, C6 zu umgehen, ist es möglich, diese Schaltungsteile durch die Parallelschaltung einer Kapazität und eines Widerstandes zu ersetzen, die die Steuereingänge des ersten und des zweiten Transistors T1 und T2 miteinander verbindet, wobei der Steuereingang des ersten und der des zweiten Transistors T1 und T2 jeweils unmittelbar an ein Bezugspotential geschaltet ist,um unter anderem die Arbeitspunkteinstellung zu ermöglichen. Eine solche Schaltungsausführung ist dann gleichwirkend mit einer Schaltung nach FIG 2, wenn der Betrag des komplexen Leitwertes, der zwischen den Steuereingängen des ersten und des zweiten Transistors T1, T2 für Wechselströme bzw. -spannungen wirksam ist, gleich groß ist. Der Betrag des komplexen Leitwertes wird hierbei in Schaltungen nach FIG 2 weitgehend durch die Serienschaltung aus der Parallelschaltung, die der Widerstand R7 mit dem Widerstand R8 und der Kapazität C5 bildet und aus der Parallelschaltung, die der Widerstand R9 mit dem Widerstand R10 und der Kapazität C6 bildet, bestimmt.

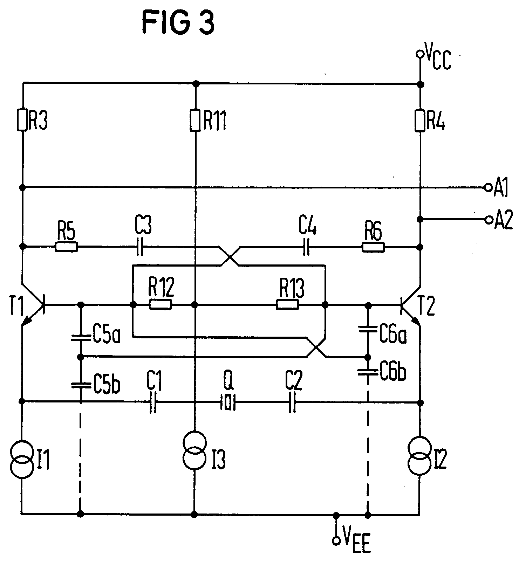

FIG 3 zeigt als besonders günstiges Ausführungsbeispiel eine Schaltungsanordnung nach FIG 2 unter Berücksichtigung von durch die monolithische Integration bedingten Besonderheiten und unter verwendung einer besonders günstigen Arbeitspunkteinstellung.

Ein in üblicher Integrationstechnik realisierter Kondensator weist zwischen den beiden Anschlußklemmen eine Kapazität auf und zusätzlich zwischen einer Anschlußklemme und dem Bezugspotential eine weitere parasitäre Kapazität. In FIG 3 ist die gewünschte Kapazität der Kondensatoren C5 und C6 jeweils mit a gekennzeichnet und die parasitäre Kapazität mit b. Die parasitären Kapazitäten solcher Kondensatoren lassen sich bei der Dimensionierung der Schaltung üblicherweise berücksichtigen, jedoch wirkt sich die dadurch bedingte Unsymmetrie der Gesamtkapazität in manchen Fällen nachteilig aus. Deshalb ist in FIG 3 eine Kapazität zwischen den Steuereingängen des ersten und des zweiten Transistors T1 und T2 durch zwei gegenparallel geschaltete Kondensatoren C5a, C5b, C6a und C6b realisiert. Aufgrund einer besonderen Arbeitspunkteinstellung ist der zu dieser Kapazität C5a, C5b, C6a und C6b parallel geschaltete Widerstand durch die Serienschaltung zweier günstigsten Falles gleich großer Widerstände, des zwölften Widerstandes R12 und des dreizehnten Widerstandes R13 realisiert, deren Verbindungsknoten über einen elften Widerstand R11 an das zweite Versorgungspotential V_{CC} und über eine dritte Stromquelle I3 an das erste Versorgungspotential V_{EE} geschaltet ist.

Werden in der Schaltung nach FIG 2 die Arbeitspunkte des ersten und des zweiten Transistors T1 und T2 über die Spannungsteiler R7, R8 bzw. R9, R10 eingestellt, so werden in der Schaltung nach FIG 3 die Arbeitspunkte des ersten und des zweiten Transistors T1 und T2 über den Spannungsteiler R11, R12 bzw. R11, R13 eingestellt, wobei der Strom durch die dritte Stromquelle I3 eingeprägt wird.

Es hat sich als günstig erwiesen, in Schaltungen nach FIG 2 oder FIG 3 die Stromquellen I1, I2 bzw. I3 miteinander zu koppeln. Hierbei hat sich der Einsatz einer sogenannten Strombank als vorteilhaft erwiesen, wobei alle Stromquellen einer Strombank gemeinsam ein- oder ausgeschaltet werden und beispielsweise auch eine gemeinsame Temperaturgangkompensation aufweisen können.

Die Eckfrequenz des Hochpaß-Teiles der Bandpaßschaltungen in einer Schaltung nach FIG 3 wird in erster Linie durch die Kapazität C4 und die Widerstände R6 und R4 bzw. durch die Kapazität C3 und die Widerstände R5 und R3 bestimmt. Die Eckfrequenz des Tiefpaß-Teiles in den Bandpaßschaltungen nach FIG 3 wird in erster Linie durch die Widerstände R12 und R13 und den differentiellen Eingangswiderstand des jeweiligen Transistors T1 oder T2 und durch die Kapazitäten C5a, C5b, C6a und C6b bestimmt.

Es liegt im Ermessen des Fachmannes eine erfindungsgemäße Schaltung in Bipolar- oder MOS-Technik auszuführen.

## Patentansprüche

1. Oszillatorschaltung mit monolithisch integrierbarem Oszillator-Verstärker, bestehend aus einem ersten Transistor (T1) und einem zweiten Transistor (T2), wobei der Emitteranschluß des ersten Transistors (T1) über eine erste Stromquelle (I1) oder einen ersten Widerstand (R1) an ein erstes Versorgungspotential (V_{EE}) geschaltet ist, wobei der Emitter des zweiten Transistors (T2) über eine zweite Stromquelle (I2) oder einen zweiten Widerstand (R2) an dieses erste Versorgungspotential (V_{EE}) geschaltet ist, wobei der Kollektoranschluß des ersten Transistors (T1) einen ersten Signalausgang (A1) bildet und über einen dritten Widerstand (R3) an ein zweites, vom ersten Versorgungspotential (V_{EE}) verschiedenes Versorgungspotential (V_{CC}) geschaltet ist, wobei der Kollektoranschluß des zweiten Transistors (T2) einen zweiten Signalausgang (A2) bildet und über einen vierten Widerstand (R4) an dieses zweite Versorgungspotential (V_{CC}) geschaltet ist, wobei der Emitteranschluß des ersten Transistors (T1) über ein Koppelglied (Q) mit stark frequenzabhängiger Impedanz mit dem Emitteranschluß des zweiten Transistors (T2) verbunden ist, wobei der erste Signalausgang (A1) an den Steuereingang des zweiten Transistors (T2) geschaltet ist und wobei der zweite Signalausgang (A2) an den Steuereingang des ersten Transistors (T1) geschaltet ist,
**dadurch gekennzeichnet**,
daß der erste Signalausgangs (A1) über eine erste Bandpaßschaltung (BP1) an den Steuereingang des zweiten Transistors (T2) geschaltet ist und daß der zweite Signalausgang (A2) über eine zweite Bandpaßschaltung (BP2) an den Steuereingang des ersten Transistors (T1) geschaltet ist.

2. Oszillatorschaltung nach Anspruch 1,
**dadurch gekennzeichnet**, daß die erste Bandpaßschaltung (BP1) realisiert ist durch eine Serienschaltung eines fünften Widerstandes (R5) und einer dritten Kapazität (C3), die den ersten Signalausgang (A1) mit dem Steuereingang des zweiten Transistors (T2) verbinden und durch eine Parallelschaltung eines neunten Widerstandes (R9) und einer sechsten Kapazität (C6), die den Steuereingang des zweiten Transistors (T2) mit einem Bezugspotential verbindet.

3. Oszillatorschaltung nach einem der vorhergehenden Ansprüche,
**dadurch gekennzeichnet**, daß die erste und die zweite Bandpaßschaltung (BP1, BP2) identisch aufgebaut sind.

4. Oszillatorschaltung nach einem der Ansprüche 1, 2 oder 3,
**dadurch gekennzeichnet**, daß der Steuereingang des ersten Transistors (T1) über die Serienschaltung eines zwölften Widerstandes (R12) und eines dreizehnten Widerstandes (R13) mit dem Steuereingang des zweiten Transistors (T2) verbunden ist, daß der Steuereingang des ersten Transistors (T1) außerdem über eine Kapazität (C5a, C5b, C6a, C6b) mit dem Steuereingang des zweiten Transistors (T2) verbunden ist, daß der Verbindungsknoten, den der zwölfte Widerstand (R12) mit dem dreizehnten Widerstand (R13) bildet über einen elften Widerstand (R11) an das zweite Versorgungspotential (V_{CC}) geschaltet ist und außerdem über eine Stromquelle (I3) an das erste Versorgungspotential (V_{EE}) geschaltet ist.

## Claims

1. Oscillator circuit having a monolithically integrable oscillator amplifier, comprising a first transistor (T1) and a second transistor (T2), the emitter connection of the first transistor (T1) being wired to a first supply potential (V_{EE}) via a first current source (I1) or via a first resistor (R1), the emitter of the second transistor (T2) being wired to this first supply potential (V_{EE}) via a second current source (I2) or via a second resistor (R2), the collector connection of the first transistor (T1) forming a first signal output (A1) and being wired via a third resistor (R3) to a second supply potential (V_{CC}) which is different from the first supply potential (V_{EE}), the collector connection of the second transistor (T2) forming a second signal output (A2) and being wired via a fourth resistor (R4) to this second supply potential (V_{CC}), the emitter connection of the first transistor (T1) being connected via a coupling element (Q) having a strong frequency-dependent impedance to the emitter connection of the second transistor (T2), the first signal output (A1) being wired to the control input of the second transistor (T2) and the second signal output (A2) being wired to the control input of the first transistor (T1), characterized in that the first signal output (A1) is wired to the control input of the second transistor (T2) via a first bandpass circuit (BP1) and in that the second signal output (A2) is wired to the control input of the first transistor (T1) via a second bandpass circuit (BP2).

2. Oscillator circuit according to Claim 1, characterized in that the first bandpass circuit (BP1) is implemented by means of a series circuit of a fifth resistor (R5) and of a third capacitance (C3), which connect the first signal output (A1) to the control input of the second transistor (T2), and by means of a parallel circuit of a ninth resistor (R9) and of a sixth capacitance (C6) which connects the control input of the second transistor (T2) to a reference potential.

3. Oscillator circuit according to one of the preceding claims, characterized in that the first and the second bandpass circuit (BP1, BP2) are constructed in an identical manner.

4. Oscillator circuit according to one of Claims 1, 2 or 3, characterized in that the control input of the first transistor (T1) is connected to the control input of the second transistor (T2) via the series circuit of a twelfth resistor (R12) and of a thirteenth resistor (R13), in that the control input of the first transistor (T1) is moreover connected to the control input of the second transistor (T2) via a second capacitance (C5a, C5b, C6a, C6b), in that the junction node which is formed by the twelfth resistor (R12) and the thirteenth resistor (R13) is wired to the second supply potential (V_{CC}) via an eleventh resistor (R11) and is moreover wired to the first supply potential (V_{EE}) via a current source (I3).

## Revendications

1. Circuit oscillateur à amplificateur oscillateur intégrable monolithiquement et constitué d'un premier transistor (T1) et d'un deuxième transistor (T2), la borne d'émetteur du premier transistor (T1) étant branchée par l'intermédiaire d'une première source (I1) de courant ou une première résistance (R1) à un premier potentiel (V_{EE}) d'alimentation, I'émetteur du deuxième transistor (T2) étant branché par l'intermédiaire d'une deuxième source (I2) de courant ou une deuxième résistance (R2) à ce premier potentiel (V_{EE}) d'alimentation, la borne de collecteur du premier transistor (T1) formant une première sortie de signal et étant branchée par l'intermédiaire d'une troisième résistance (R3) à un deuxième potentiel (V_{CC}) d'alimentation différent du premier potentiel (V_{EE}) d'alimentation, la borne de collecteur du deuxième transistor (T2) formant une deuxième sortie (A2) de signal et étant branchée par l'intermédiaire d'une quatrième résistance (R4) à ce deuxième potentiel (V_{CC}) d'alimentation, la borne d'émetteur du premier transistor (T1) étant reliée par l'intermédiaire d'un élément (Q) de couplage, dont l'impédance dépend beaucoup de la fréquence, à la borne d'émetteur du deuxième transistor (T2), la première sortie (A1) de signal étant branchée à l'entrée de commande du deuxième transistor (T2) et la deuxième sortie (A2) de signal étant branchée à l'entrée de commande du premier transistor (T1),
caractérisé en ce que
la première sortie (A1) de signal est branchée par l'intermédiaire d'un premier circuit (BP1) passe-bande à l'entrée de commande du deuxième transistor (T2) et la deuxième sortie (A2) de signal est branchée par l'intermédiaire d'un deuxième circuit (PP2) passe-bande à l'entrée de commande du premier transistor (T1).

2. Circuit oscillateur suivant la revendication 1,
caractérisé en ce que le premier circuit (VP1) passe-bande est réalisé par un circuit série formé d'une cinquième résistance (R5) et d'une troisième capacité (C3), qui relient la première sortie (A1) de signal à l'entrée de commande du deuxième transistor (T2), et par un circuit parallèle formé d'une neuvième résistance (R9) et d'une sixième capacité (C6), ce circuit parallèle reliant l'entrée de commande du deuxième transistor (T2) à un potentiel de référence.

3. Circuit oscillateur suivant l'une des revendications précédentes, caractérisé en ce que le premier et le deuxième circuits (BP1, BP2) passe-bande ont la même structure.

4. Circuit oscillateur suivant l'une revendications 1, 2 ou 3, caractérisé en ce que l'entrée de commande du premier transistor (T1) est reliée par l'intermédiaire du circuit série formé d'une douzième résistance (R12) et d'une treizième résistance (R13) à l'entrée de commande du deuxième transistor (T2), I'entrée de commande du premier transistor (T1) est en outre reliée par l'intermédiaire d'une capacité (C5a, C5b, C6a, C6b) à l'entrée de commande du deuxième transistor (T2), le noeud de liaison, que forme la douzième résistance (R12) avec la treizième résistance (R13), est branché par l'intermédiaire d'une onzième résistance (R11) au deuxième potentiel (V_{CC}) d'alimentation et est en outre branché par l'intermédiaire d'une source (I3) de courant au deuxième potentiel (V_{EE}) d'alimentation.
